(19) Europäisches Patentamt
European Patent Office
Office européen des brevets

(11) EP 3 115 992 A1

(12) EUROPEAN PATENT APPLICATION

(43) Date of publication:
11.01.2017 Bulletin 2017/02

(51) Int Cl.:
G10L 19/008 (2013.01)     G10L 21/0272 (2013.01)
H03M 1/12 (2006.01)

(21) Application number: 15306144.5

(22) Date of filing: 10.07.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA

(71) Applicant: Thomson Licensing
92130 Issy-les-Moulineaux (FR)

(72) Inventors:
• Bilen, Cagdas
35000 Rennes (FR)
• Ozerov, Alexey
35000 Rennes (FR)
• Perez, Patrick
35200 Rennes (FR)

(74) Representative: Huchet, Anne et al
TECHNICOLOR
1-5, rue Jeanne d'Arc
92130 Issy-les-Moulineaux (FR)

(54) **METHOD AND DEVICE FOR ENCODING MULTIPLE AUDIO SIGNALS, AND METHOD AND DEVICE FOR DECODING A MIXTURE OF MULTIPLE AUDIO SIGNALS WITH IMPROVED SEPARATION**

(57)    A method for encoding multiple audio signals comprises random sampling and quantizing each of the multiple audio signals, and encoding the sampled and quantized multiple audio signals as side information that can be used for decoding and separating the multiple audio signals from a mixture of said multiple audio signals. A method for decoding a mixture of multiple audio signals comprises decoding and demultiplexing side information, the side information comprising quantized samples of each of the multiple audio signals, receiving or retrieving from any data source a mixture of said multiple audio signals, and generating multiple estimated audio signals that approximate said multiple audio signals, wherein said quantized samples of each of the multiple audio signals are used.

Fig.2    a)

EP 3 115 992 A1

**Description**

Field of the invention

This invention relates to a method and a device for encoding multiple audio signals, and to a method and a device for decoding a mixture of multiple audio signals with improved separation of the multiple audio signals.

Background

The problem of audio source separation consists in estimating individual *sources* (e.g. speech, music instruments, noise, etc.) from their *mixtures.* In the context of audio, mixture means a recording of multiple sources by a single or multiple microphones. Informed source separation (ISS) for audio signals can be viewed as the problem of extracting individual audio sources from a mixture of the sources, given that some information on the sources is available. ISS relates also to compression of audio objects (sources) [6], i.e. encoding a multisource audio, given that a mixture of these sources is known on both the encoding and decoding stages. Both of these problems are interconnected. They are important for a wide range of applications.

Known solutions (e.g. [3], [4], [5]) rely on the assumption that the original sources are available during an encoding stage. Side-information is computed and transmitted along with the mixture, and both are processed in a decoding stage to recover the sources. While several ISS methods are known, in all these approaches the encoding stage is more complex and computationally expensive than the decoding stage. Therefore these approaches are not preferable in cases where the platform performing the encoding cannot handle the computational complexity demanded by the encoder. Finally, the known complex encoders are not usable for online encoding, i.e. progressively encoding the signal as it arrives, which is very important for some applications.

Summary of the Invention

In view of the above, it is highly desirable to have a fully automatic and efficient solution for both the ISS problems. In particular, a solution would be desirable where the encoder requires considerably less processing than the decoder.

The present invention provides a simple encoding scheme that shifts most of the processing load from the encoder side to the decoder side. The proposed simple way for generating the side-information enables not only low complexity encoding, but also an efficient recovery at the decoder. Finally, in contrast to some existing efficient methods that need the full signal to be known during encoding (which is called batch encoding), the proposed encoding scheme allows online encoding, i.e. the signal is progressively encoded as it arrives.

The encoder takes random samples from the audio sources with a random pattern. In one embodiment, it is a predefined pseudo-random pattern. The sampled values are quantized by a predefined quantizer and the resulting quantized samples are concatenated and losslessly compressed by an entropy coder to generate the side information. The mixture can also be produced at the encoding side, or it is already available through other ways at the decoding side. The decoder first recovers the quantized samples from the side information, and then estimates probabilistically the most likely sources within the mixture, given the quantized samples and the mixture.

In one embodiment, the present principles relate to a method for encoding multiple audio signals as disclosed in claim 1. In one embodiment, the present principles relate to a method for decoding a mixture of multiple audio signal as disclosed in claim 3.

In one embodiment, the present principles relate to an encoding device that comprises a plurality of separate hardware components, one for each step of the encoding method as described below. In one embodiment, the present principles relate to a decoding device that comprises a plurality of separate hardware components, one for each step of the decoding method as described below.

In one embodiment, the present principles relate to a computer readable medium having executable instructions to cause a computer to perform an encoding method comprising steps as described below. In one embodiment, the present principles relate to a computer readable medium having executable instructions to cause a computer to perform a decoding method comprising steps as described below.

In one embodiment, the present principles relate to an encoding device for separating audio sources, comprising at least one hardware component, e.g. hardware processor, and a non-transitory, tangible, computer-readable, storage medium tangibly embodying at least one software component, and when executing on the at least one hardware processor, the software component causes steps of the encoding method as described below. In one embodiment, the present principles relate to an encoding device for separating audio sources, comprising at least one hardware component, e.g. hardware processor, and a non-transitory, tangible, computer-readable, storage medium tangibly embodying at least one software component, and when executing on the at least one hardware processor, the software component causes steps of the decoding method as described below.

Further objects, features and advantages of the present principles will become apparent from a consideration of the following description and the appended claims when taken in connection with the accompanying drawings.

Brief description of the drawings

Exemplary embodiments are described with reference to the accompanying drawings, which show in

Fig.1 the structure of a transmission and/or storage system, comprising an encoder and a decoder;
Fig.2 the simplified structure of an exemplary encoder;
Fig.3 the simplified structure of an exemplary decoder; and
Fig.4 a performance comparison between CS-ISS and classical ISS.

Detailed description of the invention

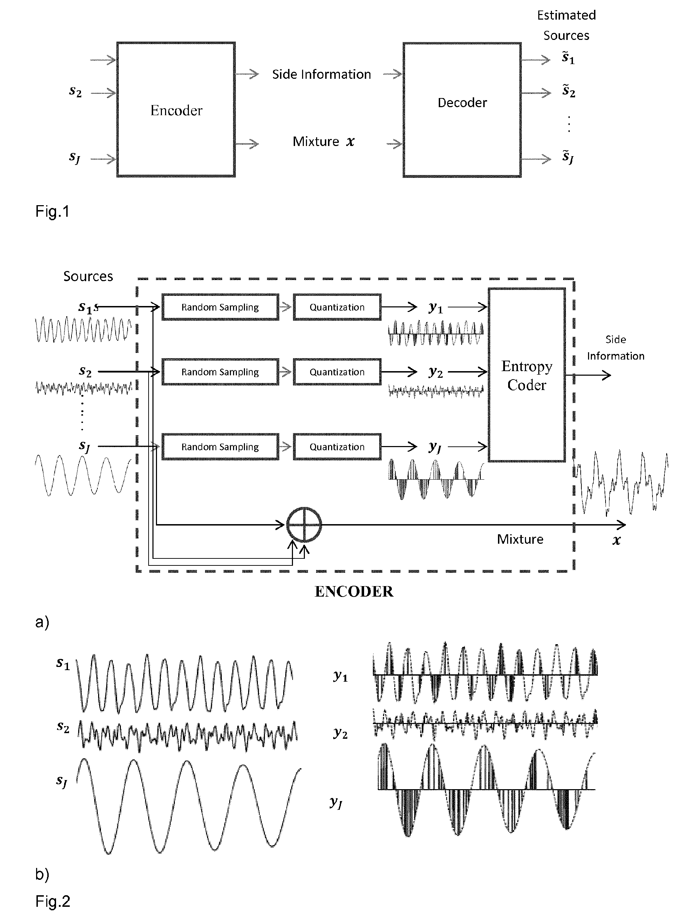

Fig.1 shows the structure of a transmission and/or storage system, comprising an encoder and a decoder. Original sound sources $s_1, s_2, ... , s_J$ are input to an encoder, which provides a mixture $x$ and side information. The decoder uses the mixture $x$ and side information to recover the sound, wherein it is assumed that some information has been lost: therefore the decoder needs to estimate the sound sources, and provides estimated sound sources $\tilde{s}_1, \tilde{s}_2, ..., \tilde{s}_J$.

It is assumed that the original sources $s_1, s_2, ..., s_J$ are available at the encoder, and are processed by the encoder to generate the side information. The mixture can also be generated by the encoder, or it can be available by other means at the decoder. For example, for a known audio track available on the internet, side information generated from individual sources can be stored, e.g. by the authors of the audio track or others. One problem described herein is having single channel audio sources recorded with single microphones, which are added together to form the mixture. Other configurations, e.g. multichannel audio or recordings with multiple microphones, can easily be handled by extending the described methods in a straight forward manner.

One technical problem that is considered here within the above-described setting consists in: when having an encoder to generate the side information, design a decoder that can estimate sources $\tilde{s}_1, \tilde{s}_2, ..., \tilde{s}_J$ that are as close as possible to the original sources $s_1, s_2, ... , s_J$. The decoder should use the side information and the known mixture $x$ in an efficient manner so as to minimize the needed size of the side information for a given quality of the estimated sources. It is assumed that the decoder knows both the mixture and how it is formed using the sources. Therefore the invention comprises two parts: the encoder and the decoder.

Fig.2 a) shows the simplified structure of an exemplary encoder. The encoder is designed to be computationally simple. It takes random samples from the audio sources. In one embodiment, it uses a predefined pseudo-random pattern. In another embodiment, it uses any random pattern. The sampled values are quantized by a (predefined) quantizer, and the resulting quantized samples $y_1, y_2, ..., y_J$ are concatenated and losslessly compressed by an entropy coder (e.g. Huffman coder or arithmetic coder) to generate the side information. The mixture is also produced, if not already available at the decoding side.

Fig.2 b) shows, enlarged, exemplary signals within the encoder. A mixture signal $x$ is obtained by overlaying or mixing different source signals $s_1, s_2, ..., s_J$. Each of the source signals $s_1, s_2, ..., s_J$ is also random sampled in random sampling units, and the samples are quantized in one or more quantizers (in this embodiment, one quantizer for each signal) to obtain quantized samples $y_1, y_2, ... , y_J$. The quantized samples are encoded to be used as side information. Note that, in other embodiments, the sequence order of sampling and quantizing may be swapped.

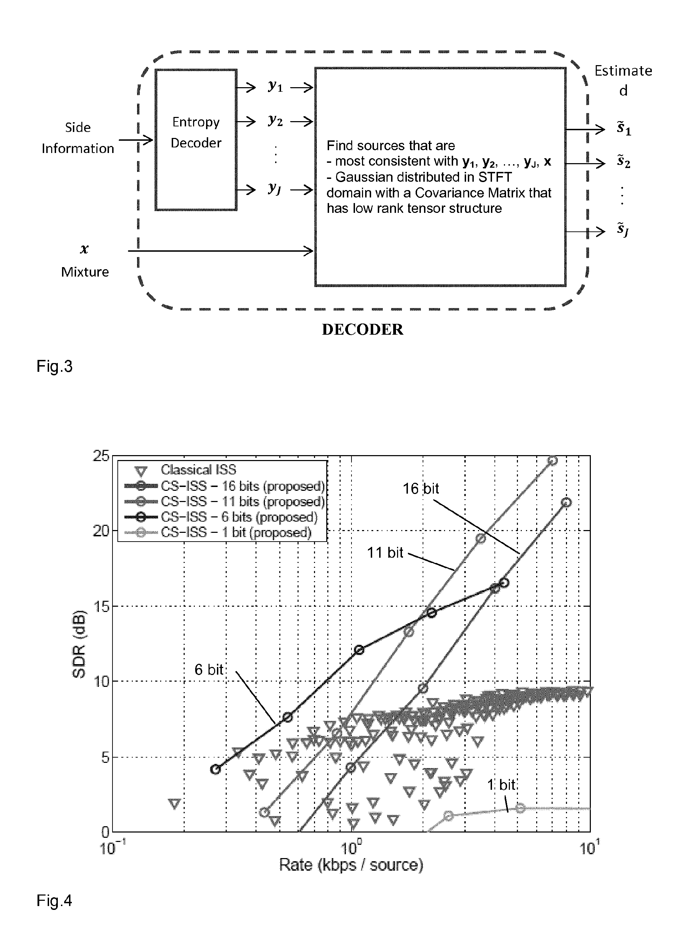

Fig.3 shows the simplified structure of an exemplary decoder. The decoder first recovers the quantized samples $y_1, y_2, ..., y_J$ from the side information. It then estimates probabilistically the most likely sources $\tilde{s}_1, \tilde{s}_2, ..., \tilde{s}_J$, given the observed samples $y_1, y_2, ... , y_J$ and the mixture $x$ and exploiting the known structures and correlations among the sources.

Possible implementations of the encoder are very simple. One possible implementation of the decoder operates based on the following two assumptions:

(1) The sources are jointly Gaussian distributed in the Short-Time Fourier Transform (STFT) domain with window size F and number of windows N.

(2) The variance tensor of the Gaussian distribution $V \in \mathrm{R}_+^{F \times N \times J}$ has a low rank Non-Negative Tensor Decomposition (NTF) of rank K such that

$$V(f,n,j) = \sum_{k=1}^{K} H(n,k)W(f,k)Q(j,k), \qquad H \in \mathrm{R}_+^{N \times K}, W \in \mathrm{R}_+^{F \times K}, Q \in \mathrm{R}_+^{J \times K}$$

Following these two assumptions, the operation of the decoder can be summarized with the following steps:

1. Initialize matrices $H \in \mathrm{R}_+^{N \times K}$, $W \in \mathrm{R}_+^{F \times K}$, $Q \in \mathrm{R}_+^{J \times K}$ with random nonnegative values and compute the variance tensor $V \in \mathrm{R}_+^{F \times N \times J}$ as :

$$V(f,n,j) = \sum_{k=1}^{K} H(n,k)W(f,k)Q(j,k)$$

2. Until convergence or maximum number of iterations reached, repeat:

2.1 Compute the conditional expectations of the source power spectra such that

$$P(f,n,j) = \mathrm{E}\{|S(f,n,j)|^2 | x, y_1, y_2, \dots, y_J, V\}$$

where $S \in C^{F \times N \times J}$ are the array of the STFT complex coefficients of the sources. More details on this conditional expectation computation are provided below.

2.2 Re-estimate NTF model parameters $H \in \mathrm{R}_+^{N \times K}$, $W \in \mathrm{R}_+^{F \times K}$, $Q \in \mathrm{R}_+^{J \times K}$ using the multiplicative update (MU) rules minimizing the IS divergence [15] between the 3-valence tensor of estimated source power spectra $P(f, n, j)$ and the 3-valence tensor of the NTF model approximation $V(f,n,j)$ such that:

$$Q(j,k) \leftarrow Q(j,k) \left( \frac{\sum_{f,n} W(f,k)H(n,k)P(f,n,j)\,V(f,n,j)^{-2}}{\sum_{f,n} W(f,k)H(n,k)V(f,n,j)^{-1}} \right)$$

$$W(f,k) \leftarrow W(f,k) \left( \frac{\sum_{j,n} Q(j,k)H(n,k)P(f,n,j)\,V(f,n,j)^{-2}}{\sum_{j,n} Q(j,k)H(n,k)V(f,n,j)^{-1}} \right)$$

$$H(n,k) \leftarrow H(n,k) \left( \frac{\sum_{f,j} W(f,k)Q(j,k)P(f,n,j)\,V(f,n,j)^{-2}}{\sum_{f,j} W(f,k)Q(j,k)V(f,n,j)^{-1}} \right)$$

These updates can be iteratively repeated multiple times.

3. Compute the array of STFT coefficients $S \in C^{F \times N \times J}$ as the posterior mean as

$$\widehat{S}(f,n,j) = \mathrm{E}\{S(f,n,j) | x, y_1, y_2, \dots, y_J, V\}$$

and convert back into the time domain to recover the estimated sources $\tilde{s}_1, \tilde{s}_2, \dots, \tilde{s}_J$. More details on this posterior mean computation are provided below.

The following describes some mathematical basics on the above calculations.
A tensor is a data structure that can be seen as a higher dimensional matrix. A matrix is 2-dimensional, whereas a tensor can be N-dimensional. In the present case, V is a 3-dimensional tensor (like a cube). It represents the covariance matrix of the jointly Gaussian distribution of the sources.

A matrix can be represented as the sum of few rank-1 matrices, each formed by multiplying two vectors, in the low rank model. In the present case, the tensor is similarly represented as the sum of K rank one tensors, where a rank one tensor is formed by multiplying three vectors, e.g. $h_i$, $q_i$ and $w_i$. These vectors are put together to form the matrices **H, Q** and **W**. There are K sets of vectors for the K rank one tensors. Essentially, the tensor is represented by K components, and the matrices **H, Q** and **W** represent how the components are distributed along different frames, different frequencies of STFT and different sources respectively. Similar to a low rank model in matrices, K is kept small because a small K better defines the characteristics of the data, such as audio data, e.g. music. Hence it is possible to guess unknown characteristics of the signal by using the information that V should be a low rank tensor. This reduces the number of unknowns and defines an interrelation between different parts of the data.

The steps of the above-described iterative algorithm can be described as follows. First, initialize the matrices **H, Q** and **W** and therefore **V.**

Given V, the probability distribution of the signal is known. And looking at the observed part of the signals (signals are observed only partially), it is possible to estimate the STFT coefficients $\hat{S}$, e.g. by Wiener filtering. This is the posterior mean of the signal. Further, also a posterior covariance of the signal is computed, which will be used below. This step is performed independently for each window of the signal, and it is parallelizable. This is called the expectation step or E-step.

Once the posterior mean and covariance are computed, these are used to compute the posterior power spectra **p**. This is needed to update the earlier model parameters, ie. **H, Q** and **W**. It may be advantageous to repeat this step more than once in order to reach a better estimate (e.g. 2-10 times). This is called the maximization step or M-step. Once the model parameters **H, Q** and **W** are updated, all the steps (from estimating the STFT coefficients $\hat{S}$) can be repeated until some convergence is reached, in an embodiment. After the convergence is reached, in an embodiment the posterior mean of the STFT coefficients $\hat{S}$ is converted into the time domain to obtain an audio signal as final result.

One advantage of the invention is that it allows improved recovering of multiple audio source signals from a mixture thereof. This enables efficient storage and transmission of a multisource audio recording without the need for powerful devices. Mobile phones or tablets can easily be used to compress information regarding the multiple sources of an audio track without a heavy battery drain or processor utilization.

A further advantage is that the computational resources for encoding and decoding the sources are more efficiently utilized, since the compressed information on the individual sources are decoded only if they are needed. In some applications, such as music production, the information on the individual sources are always encoded and stored, however it is not always needed and accessed afterwards. Therefore, as opposed to an expensive encoder that performs high complexity processing on every encoded audio stream, a system with a low complexity encoder and a high complexity decoder has the benefit of utilizing the processing power only for those audio streams for which the individual sources are actually needed later.

A third advantage provided by the invention is the adaptability to new and better decoding methods. When a new and improved way of exploiting correlations within the data is discovered, a new method for decoding can be devised (a better method to estimate $\tilde{s}_1, \tilde{s}_2, ..., \tilde{s}_J$ given $x, y_1, y_2, ..., y_J$), and it is possible to decode the older encoded bitstreams with better quality without the need to re-encode the sources. Whereas in traditional encoding-decoding paradigms, when an improved way of exploiting correlations within the data leads to a new method of encoding, it is necessary to decode and re-encode the sources in order to exploit the advantages of the new approach. Furthermore, the process of re-encoding an already encoded bitstream is known to introduce further errors with respect to the original sources.

A fourth advantage of the invention is the possibility to encode the sources in an online fashion, i.e. the sources are encoded as they arrive to the encoder, and the availability of the entire stream is not necessary for encoding.

A fifth advantage of the invention is that gaps in the separated audio source signals can be repaired, which is known as audio inpainting. Thus, the invention allows joint audio inpainting and source separation, as described in the following.

The approach disclosed herein is inspired by distributed source coding [9] and in particular distributed video coding [10] paradigms, where the goal is also to shift the complexity from the encoder to the decoder. The approach relies on the compressive sensing/sampling principles [11-13], since the sources are projected on a linear subspace spanned by a randomly selected subset of vectors of a basis that is incoherent [13] with a basis where the audio sources are sparse. The disclosed approach can be called *compressive sampling-based ISS (CS-ISS).* More specifically, it is proposed to encode the sources by a simple random selection of a subset of temporal samples of the sources, followed by a uniform quantization and an entropy encoder. In one embodiment, this is the only side-information transmitted to the decoder.

Note that the advantage of sampling in the time domain is double. First, it is faster than sampling in any transformed domain. Second, the temporal basis is incoherent enough with the short time Fourier transform (STFT) frame where audio signals are sparse and it is even more incoherent with the low rank NTF representation of STFT coefficients. It is shown in compressive sensing theory that the incoherency of the measurement and prior information domains is essential for the recovery of the sources [13].

To recover the sources at the decoder from the quantized source samples and the mixture, it is proposed to use a model-based approach that is in line with model-based compressive sensing [14]. Notably, in one embodiment the Itakura-Saito (IS) nonnegative tensor factorization (NTF) model of source spectrograms is used, as in [4,5]. Thanks to its Gaussian probabilistic formulation [15], this model may be estimated in the maximum-likelihood (ML) sense from the mixture and the transmitted quantized portion of source samples. To estimate the model, a new generalized expectation-maximization (GEM) algorithm [16] based on multiplicative update (MU) rules [15] can be used. Given the estimated model and all other observations, the sources can be estimated by Wiener filtering [17].

OVERVIEW OF THE CS-ISS FRAMEWORK

The overall structure of the proposed CS-ISS encoder/decoder is depicted in Fig.2, as already explained above. The encoder randomly subsamples the sources with a desired rate, using a predefined randomization pattern, and quantizes these samples. The quantized samples are then ordered in a single stream to be compressed with an entropy encoder to form the final encoded bitstream. The random sampling pattern (or a seed that generates the random pattern) is known by both the encoder and decoder and therefore needs not be transmitted, in one embodiment. In another embodiment, the random sampling pattern, or a seed that generates the random pattern, is transmitted to the decoder. The audio mixture is also assumed to be known by the decoder. The decoder performs entropy decoding to retrieve the quantized samples of the sources, followed by CS-ISS decoding as will be discussed in detail below.

The proposed CS-ISS framework has several advantages over traditional ISS, which can be summarized as follows:

A first advantage is that the simple encoder in Fig.2 can be used for low complexity encoding, as needed e.g. in low power devices. A low-complexity encoding scheme is also advantageous for applications where encoding is used frequently but only few encoded streams need to be decoded. An example of such an application is music production in a studio where the sources of each produced music are kept for future use, but are seldom needed. Hence, significant savings in terms of processing power and processing time is possible with CS-ISS.

A second advantage is that performing sampling in time domain (and not in a transformed domain) provides not only a simple sampling scheme, but also the possibility to perform the encoding in an online fashion when needed, which is not always as straight forward for other methods [4,5]. Furthermore, the independent encoding scheme enables the possibility of encoding sources in a *distributed* manner without compromising the decoding efficiency.

A third advantage is that the encoding step is performed without any assumptions on the decoding step. Therefore it is possible to use other decoders than the one proposed in this embodiment. This provides a significant advantage over classical ISS [2-5] in the sense that, when a better performing decoder is designed, the encoded sources can directly benefit from the improved decoding without the need for re-encoding. This is made possible by the random sampling used in the encoder. The compressive sensing theory shows that a random sampling scheme provides incoherency with a large number of domains, so that it becomes possible to design efficient decoders relying on different prior information on the data.

CS-ISS DECODER

Let us indicate the support of the random samples with $\Omega''$, such that the source $j \in [\![1, J]\!]$ is sampled at time indices $t \in \Omega''_j \subseteq [\![1, T]\!]$. After the entropy decoding stage, the CS-ISS decoder has the subset of quantized samples of the sources $y''_{jt}(\Omega''_j), j \in [\![1, J]\!]$, where the quantized samples are defined as

$$y''_{jt} = s''_{jt} + b''_{jt} \qquad\qquad (1)$$

where $s''_{jt}$ indicates the true source signal and $b''_{jt}$ is the quantization noise. Note that herein the time-domain signals are represented by letters with two primes, e.g. x", while framed and windowed time-domain signals are denoted by letters with one prime, e.g. x', and complex-valued short-time Fourier transform (STFT) coefficients are denoted by letters with no prime, e.g. x.

The mixture is assumed to be the sum of the original sources such that

$$x''_t = \sum_{j=1}^{J} s''_{jt}, \quad t \in [\![1, T]\!], \; j \in [\![1, J]\!] \qquad\qquad (2)$$

The mixture is assumed to be known at the decoder. Note that the mixture is assumed to be noise free and without quantization herein. However, the disclosed algorithm can as well easily be extended to include noise in the mixture. In order to compute the STFT coefficients, the mixture and the sources are first converted to a windowed time domain with a window length M and a total of N windows. Resulting coefficients denoted by $y'_{jmn}$, $s'_{jmn}$ and $x'_{mn}$ represent the quantized sources, the original sources and the mixture in windowed-time domain respectively for j = 1,...,J, n = 1,...,N and m = 1,...,M (only for m in appropriate subset $\Omega'_{jn}$ in case of quantized source samples). The STFT coefficients of the sources, $S_{jfn}$, and of the mixture, $x_{fn}$, are computed by applying the unitary Fourier transform $U \in \mathbb{C}^{F \times M}$ (F=M), to each window of the windowed-time domain counterparts. For example, $[\mathsf{x}_{1n}, \ldots, \mathsf{x}_{Fn}]^{\mathsf{T}} = U[x'_{1n}, \ldots, x'_{Mn}]^{\mathsf{T}}$.

The sources are modelled in the STFT domain with a normal distribution $(s_{jfn} \sim N_c(0, v_{jfn})$ where the variance tensor V = $[v_{jfn}]_{j,f,n}$ has the following low-rank NTF structure [18]:

$$v_{jfn} = \sum_{k=1}^{K} q_{jk} \, w_{fk} \, h_{nk} \, , K < \max(J, F, N) \qquad (3)$$

The model is parametrized by $\Theta$ = {Q, W, H}, with $Q = [q_{jk}] \in \mathbb{R}_+^{J \times K}$, $W = [w_{fk}] \in \mathbb{R}_+^{F \times K}$ and $H = [h_{nk}] \in \mathbb{R}_+^{N \times K}$.

According to an embodiment of the present principles, the source signals are recovered with a generalized expectation-maximization algorithm that is briefly described in Algorithm 1. The algorithm estimates the sources and source statistics from the observations using a given model $\Theta$ via Wiener filtering at the expectation step, and then updates the model using the posterior source statistics at the maximization step. The details on each step of the algorithm are given below.

---

**Algorithm 1** GEM algorithm for CS-ISS Decoding using the NTF model

1:     **procedure** CS-ISS DECODING $\left( \mathbf{x}', \{y'_j\}_1^J, \{\Omega'_j\}_1^J, K \right)$

2:         Initialize non-negative **Q, W, H** randomly

3:         **repeat**

4:         Estimate s (sources) and $\hat{\mathbf{P}}$ (posterior power spectra), given Q. **W, H,** $x'$, $\{y'_j\}_1^J$, $\{\Omega'_j\}_1^J$

        ▷ E-step. see section 3.1

5:         Update **Q, W, H** given **P** ▷ M-step, see section 3.2

6:         **until** convergence criteria met

7:     **end procedure**

---

Estimating the sources

Since all the underlying distributions are Gaussian and all the relations between the sources and the observations are linear, the sources may be estimated in the minimum mean square error (MMSE) sense via the Wiener filter [17], given the covariance tensor V defined in (3) by the model parameters Q,W,H.

Let the observed data vector for the n-th frame $\bar{o}'_n$ be defined as $\bar{o}'_n \triangleq [\bar{y}'^T_{1n}, \ldots, \bar{y}'^T_{jn}, \bar{x}'^T_n]^{\mathsf{T}}$, where $\bar{x}'_n \triangleq [x'_{1n}, \ldots, x'_{Mn}]^{\mathsf{T}}$ and $\bar{y}'_{jn} \triangleq [y'_{jmn}, m \in \Omega'_{jn}]^{\mathsf{T}}$.

Given the corresponding observed data $\bar{o}'_n$ and the NTF model $\Theta$, the posterior distribution of each source frame $s_{jn}$ can be written as $s_{jn} | \bar{o}'_n; \Theta \sim N_c(\hat{s}_{jn}, \hat{\Sigma}_{s_{jn}s_{jn}})$ with $\hat{s}_{jn}$ and $\hat{\Sigma}_{s_{jn}s_{jn}}$ being, respectively, posterior mean and posterior covariance matrix. Each of them can be computed by Wiener filtering as

$$\hat{\mathbf{s}}_{jn} = \boldsymbol{\Sigma}_{\bar{\mathbf{o}}'_n \mathbf{s}_{jn}}^{H} \boldsymbol{\Sigma}_{\bar{\mathbf{o}}'_n \bar{\mathbf{o}}'_n}^{-1} \bar{\mathbf{o}}'_n, \tag{4}$$

$$\widehat{\boldsymbol{\Sigma}}_{\mathbf{s}_{jn}\mathbf{s}_{jn}} = \boldsymbol{\Sigma}_{\mathbf{s}_{jn}\mathbf{s}_{jn}} - \boldsymbol{\Sigma}_{\bar{\mathbf{o}}'_n \mathbf{s}_{jn}}^{H} \boldsymbol{\Sigma}_{\bar{\mathbf{o}}'_n \bar{\mathbf{o}}'_n}^{-1} \boldsymbol{\Sigma}_{\bar{\mathbf{o}}'_n \mathbf{s}_{jn}}, \tag{5}$$

given the definitions

$$\boldsymbol{\Sigma}_{\bar{\mathbf{o}}'_n \bar{\mathbf{o}}'_n} = \begin{bmatrix} \boldsymbol{\Sigma}_{\bar{\mathbf{y}}'_{1n} \bar{\mathbf{y}}'_{1n}} & \cdots & \underline{\mathbf{0}} & \boldsymbol{\Sigma}_{\bar{\mathbf{x}}'_n \bar{\mathbf{y}}'_{1n}}^{H} \\ \vdots & \ddots & \vdots & \vdots \\ \underline{\mathbf{0}} & \cdots & \boldsymbol{\Sigma}_{\bar{\mathbf{y}}'_{Jn} \bar{\mathbf{y}}'_{Jn}} & \boldsymbol{\Sigma}_{\bar{\mathbf{x}}'_n \bar{\mathbf{y}}'_{Jn}}^{H} \\ \boldsymbol{\Sigma}_{\bar{\mathbf{x}}'_n \bar{\mathbf{y}}'_{1n}} & \cdots & \boldsymbol{\Sigma}_{\bar{\mathbf{x}}'_n \bar{\mathbf{y}}'_{Jn}} & \boldsymbol{\Sigma}_{\bar{\mathbf{x}}'_n \bar{\mathbf{x}}'_n} \end{bmatrix}, \tag{6}$$

$$\boldsymbol{\Sigma}_{\bar{\mathbf{o}}'_n \mathbf{s}_{jn}} = \begin{bmatrix} \underline{\mathbf{0}}_{S_1 \times F}^{T}, \boldsymbol{\Sigma}_{\bar{\mathbf{y}}'_{jn} \mathbf{s}_{jn}}^{T}, \underline{\mathbf{0}}_{S_2 \times F}^{T}, \boldsymbol{\Sigma}_{\bar{\mathbf{x}}'_n \mathbf{s}_{jn}}^{T} \end{bmatrix}^{T},$$

$$S_1 \triangleq \sum_{\hat{j}=1}^{j-1} |\Omega'_{\hat{j}n}|, \quad S_2 \triangleq \sum_{\hat{j}=j+1}^{J} |\Omega'_{\hat{j}n}|, \tag{7}$$

$$\boldsymbol{\Sigma}_{\mathbf{s}_{jn}\mathbf{s}_{jn}} = \operatorname{diag}\left([v_{jfn}]_f\right), \tag{8}$$

$$\boldsymbol{\Sigma}_{\bar{\mathbf{y}}'_{jn}\bar{\mathbf{y}}'_{jn}} = \mathbf{U}(\Omega'_{jn})^{H} \operatorname{diag}\left([v_{jfn}]_f\right) \mathbf{U}(\Omega'_{jn}), \tag{9}$$

$$\boldsymbol{\Sigma}_{\bar{\mathbf{y}}'_{jn}\mathbf{s}_{jn}} = \mathbf{U}(\Omega'_{jn})^{H} \operatorname{diag}\left([v_{jfn}]_f\right), \tag{10}$$

$$\boldsymbol{\Sigma}_{\bar{\mathbf{x}}'_n \mathbf{s}_{jn}} = \mathbf{U}^{H} \operatorname{diag}\left([v_{jfn}]_f\right), \tag{11}$$

$$\boldsymbol{\Sigma}_{\bar{\mathbf{x}}'_n \bar{\mathbf{x}}'_n} = \mathbf{U}^{H} \operatorname{diag}\left(\left[\sum_j v_{jfn}\right]_f\right) \mathbf{U}, \tag{12}$$

$$\boldsymbol{\Sigma}_{\bar{\mathbf{x}}'_n \bar{\mathbf{y}}'_{jn}} = \mathbf{U}^{H} \operatorname{diag}\left([v_{jfn}]_f\right) \mathbf{U}(\Omega'_{jn}), \tag{13}$$

where $\mathsf{U}(\Omega'_{jn})$ is the $F \times |\Omega'_{jn}|$ matrix of columns from U with index in $\Omega'_{jn}$. Therefore the posterior power spectra $\hat{P} = [\hat{p}_{jfn}]$ that will be used to update the NTF model as described below, can be computed as

$$\hat{p}_{jfn} = \mathbb{E}\left[ |s_{jfn}|^2 \Big| \bar{\mathbf{o}}'_n; \theta \right] = |\hat{s}_{jfn}|^2 + \widehat{\Sigma}_{\mathbf{s}_{jn}\mathbf{s}_{jn}}(f,f). \quad (14)$$

Updating the model

NTF model parameters can be re-estimated using the multiplicative update (MU) rules minimizing the IS divergence [15] between the 3-valence tensor of estimated source power spectra P and the 3-valence tensor of the NTF model approximation V defined as $D_{IS}(\widetilde{P}||\mathbf{V}) = \sum_{j,f,n} d_{IS}(\tilde{p}_{jfn}||v_{jfn})$, where $d_{IS}(x||y) = \frac{x}{y} - \log\left(\frac{x}{y}\right) - 1$ is the IS divergence; and $\tilde{p}_{jfn}$ and $v_{jfn}$ are specified by (14) and (3). As a result, Q,W,H can be updated with the MU rules presented in [18]. These MU rules can be repeated several times to improve the model estimate.

Results

In order to assess the performance of the present approach, three sources of a music signal at 16 kHz are encoded and then decoded using the proposed CS-ISS with different levels of quantization (16 bits, 11 bits, 6 bits and 1 bit) and different sampling bitrates per source (0.64, 1.28, 2.56, 5.12 and 10.24 kbps/source). In this example, it is assumed that the random sampling pattern is *pre-defined* and known during both encoding and decoding. The quantized samples are truncated and compressed using an arithmetic encoder with a zero mean Gaussian distribution assumption. At the decoder side, following the arithmetic decoder, the sources are decoded from the quantized samples using 50 iterations of the GEM algorithm with STFT computed using a half-overlapping sine window of 1024 samples (64 ms) with a Gaussian window function and the number of components fixed at K = 18, i.e. 6 components per source. The quality of the reconstructed samples is measured in signal to distortion ratio (SDR) as described in [19]. The resulting encoded bitrates and SDR of decoded signals are presented in Tab.1 along with the percentage of the encoded samples in parentheses. Note that the compressed rates in Tab.1 differ from the corresponding raw bitrates due to the variable performance of the entropy coding stage, which is expected.

Table 1: The final bitrates (in kbps per source) after the entropy coding stage of CS-ISS with corresponding SDR (in dBs) for different (uniform) quantization levels and different raw bitrates before entropy coding. The percentage of the samples kept is also provided for each case in parentheses. Results corresponding to the best rate-distortion compromise are in bold.

| Bits per Sample | Compressed Rate / SDR (% of Samples Kept) | | | | |
| --- | --- | --- | --- | --- | --- |
| | Raw rate (kbps / source) | | | | |
| | **0.64** | **1.28** | **2.56** | **5.12** | **10.24** |
| **16 bits** | 0.50 / -1.64 (0.25) | 1.00 / 4.28 (0.50) | 2.00 / 9.54 (1.00) | 4.01 / 16.17 (2.00) | 8.00 / 21.87 (4.00) |
| **11 bits** | 0.43 / 1.30 (0.36) | 0.87 / 6.54 (0.73) | 1.75 / 13.30 (1.45) | **3.50 / 19.47** (2.91) | **7.00 / 24.66** (5.82) |
| **6 bits** | **0.27 / 4.17** (0.67) | **0.54 / 7.62** (1.33) | **1.08 / 12.09** (2.67) | 2.18 / 14.55 (5.33) | 4.37 / 16.55 (10.67) |
| **1 bit** | 0.64 / -5.06 (4.00) | 1.28 / -2.5 (8.00) | 2.56 / 1.08 (16.00) | 5.12 1.59 (32.00) | 10.24 / 1.56 (64.00) |

The performance of CS-ISS is compared to the classical ISS approach with a more complicated encoder and a simpler decoder presented in [4]. The ISS algorithm is used with NTF model quantization and encoding as in [5], i.e., NTF coefficients are uniformly quantized in logarithmic domain, quantization step sizes of different NTF matrices are computed using equations (31)-(33) from [5] and the indices are encoded using an arithmetic coder based on a two states Gaussian mixture model (GMM) (see Fig. 5 of [5]). The approach is evaluated for different quantization step sizes and different numbers of NTF components, i.e. $\Delta = 2^{-2}, 2^{-1.5}, 2^{-1}, ..., 2^4$ and K = 4, 6,..., 30. The results are generated with 250 iterations of model update. The performance of both CS-ISS and classical ISS are shown in Fig.4, in which CS-ISS clearly outperforms the ISS approach, even though the ISS approach can use optimized number of components and quantization as opposed to our decoder which uses a fixed number of components (the encoder is very simple and does not compute this value). The performance difference is due to the high efficiency achieved by the CS-ISS decoder thanks to the incoherency of random sampled time domain and of low rank NTF domain. Also, the ISS approach is unable to perform beyond an SDR of 10 dBs due to the lack of fidelity in the encoder structure as explained in [5]. Even though it was not possible to compare to the ISS algorithm presented in [5] in this paper due to time constraints, the results indicate that the rate distortion performance exhibits a similar behavior. It should be reminded that the proposed approach distinguishes itself by it low complexity encoder and hence can still be advantageous against other ISS approaches with better rate distortion performance.

The performance of CS-ISS in Tab.1 and Fig.4 indicates that different levels of quantization may be preferable in different rates. Even though neither 16 bits nor 1 bit quantization seem well performing, the performance indicates that 16 bits quantization may be superior to other schemes when a much higher bitrate is available. Similarly coarser quantization such as 1 bit may be beneficial when considering significantly low bitrates. The choice of quantization can be performed in the encoder with a simple look up table as a reference. One must also note that even though the encoder in CS-ISS is very simple, the proposed decoder is significantly high complexity, typically higher than the encoders of traditional ISS methods. However, this can also be overcome by exploiting the independence of Wiener filtering among the frames in the proposed decoder with parallel processing, e.g. using graphical processing units (GPUs).

The disclosed solution usually leads to the fact that a low-rank tensor structure appears in the power spectrogram of the reconstructed signals.

It is to be noted that the use of the verb "comprise" and its conjugations does not exclude the presence of elements or steps other than those stated in a claim. Furthermore, the use of the article "a" or "an" preceding an element does not exclude the presence of a plurality of such elements. Several "means" may be represented by the same item of hardware. Furthermore, the invention resides in each and every novel feature or combination of features. As used herein, a "digital audio signal" or "audio signal" does not describe a mere mathematical abstraction, but instead denotes information embodied in or carried by a physical medium capable of detection by a machine or apparatus. This term includes recorded or transmitted signals, and should be understood to include conveyance by any form of encoding, including pulse code modulation (PCM), but not limited to PCM.

While there has been shown, described, and pointed out fundamental novel features of the present invention as applied to preferred embodiments thereof, it will be understood that various omissions and substitutions and changes in the apparatus and method described, in the form and details of the devices disclosed, and in their operation, may be made by those skilled in the art without departing from the spirit of the present invention. It is expressly intended that all combinations of those elements that perform substantially the same function in substantially the same way to achieve the same results are within the scope of the invention. Substitutions of elements from one described embodiment to another are also fully intended and contemplated. Each feature disclosed in the description and (where appropriate) the claims and drawings may be provided independently or in any appropriate combination. Features may, where appropriate be implemented in hardware, software, or a combination of the two. Connections may, where applicable, be implemented as wireless connections or wired, not necessarily direct or dedicated, connections.

Cited References

[1] E. Vincent, S. Araki, F. J. Theis, G. Nolte, P. Bofill, H. Sawada, A. Ozerov, B. V. Gowreesunker, D. Lutter, and N. Q. K. Duong, "The signal separation evaluation campaign (2007-2010): Achievements and remaining challenges," Signal Processing, vol. 92, no. 8, pp. 1928-1936, 2012.

[2] M. Parvaix, L. Girin, and J.-M. Brossier, "A watermarkingbased method for informed source separation of audio signals with a single sensor," IEEE Trans. Audio, Speech, Language Process., vol. 18, no. 6, pp. 1464-1475, 2010.

[3] M. Parvaix and L. Girin, "Informed source separation of linear instantaneous under-determined audio mixtures by source index embedding," IEEE Trans. Audio, Speech, Language Process., vol. 19, no. 6, pp. 1721 - 1733, 2011.

[4] A. Liutkus, J. Pinel, R. Badeau, L. Girin, and G. Richard, "Informed source separation through spectrogram coding and data embedding," Signal Processing, vol. 92, no. 8, pp. 1937- 1949, 2012.

[5] A. Ozerov, A. Liutkus, R. Badeau, and G. Richard, "Coding-based informed source separation: Nonnegative tensor factorization approach," IEEE Transactions on Audio, Speech, and Language Processing, vol. 21, no. 8, pp. 1699-1712, Aug. 2013.

[6] J. Engdegard, B. Resch, C. Falch, O. Hellmuth, J. Hilpert, A. H" olzer, L. Terentiev, J. Breebaart, J. Koppens, E. Schuijers, and W. Oomen, "Spatial audio object coding (SAOC) - The upcoming MPEG standard on parametric object based audio coding," in 124th Audio Engineering Society Convention (AES 2008), Amsterdam, Netherlands, May 2008.

[7] A. Ozerov, A. Liutkus, R. Badeau, and G. Richard, "Informed source separation: source coding meets source separation," in IEEE Workshop Applications of Signal Processing to Audio and Acoustics (WASPAA'11), New Paltz, New York, USA, Oct. 2011, pp. 257-260.

[8] S. Kirbiz, A. Ozerov, A. Liutkus, and L. Girin, "Perceptual coding-based informed source separation," in Proc. 22nd European Signal Processing Conference (EUSIPCO), 2014, pp. 959-963.

[9] Z. Xiong, A. D. Liveris, and S. Cheng, "Distributed source coding for sensor networks," IEEE Signal Processing Magazine, vol. 21, no. 5, pp. 80-94, September 2004.

[10] B. Girod, A. Aaron, S. Rane, and D. Rebollo-Monedero, "Distributed video coding," Proceedings of the IEEE, vol. 93, no. 1, pp. 71 - 83, January 2005.

[11] D. Donoho, "Compressed sensing," IEEE Trans. Inform. Theory, vol. 52, no. 4, pp. 1289-1306, Apr. 2006.

[12] R. G. Baraniuk, "Compressive sensing," IEEE Signal Processing Mag., vol. 24, no. 4, pp. 118-120, July 2007.

[13] E. J. Candes and M. B. Wakin, "An introduction to compressive sampling," IEEE Signal Processing Magazine, vol. 25, pp. 21-30, 2008.

[14] R. G. Baraniuk, V. Cevher, M. F. Duarte, and C. Hegde, "Model-based compressive sensing," IEEE Trans. Info. Theory, vol. 56, no. 4, pp. 1982-2001, Apr. 2010.

[15] C. Fevotte, N. Bertin, and J.-L. Durrieu, "Nonnegative matrix factorization with the Itakura-Saito divergence. With application to music analysis," Neural Computation, vol. 21, no. 3, pp. 793-830, Mar. 2009.

[16] A. P. Dempster, N. M. Laird, and D. B. Rubin., "Maximum likelihood from incomplete data via the EM algorithm," Journal of the Royal Statistical Society. Series B (Methodological), vol. 39, pp. 1-38, 1977.

[17] S.M. Kay, Fundamentals of Statistical Signal Processing: Estimation Theory. Englewood Cliffs, NJ: Prentice Hall, 1993.

[18] A. Ozerov, C. Fevotte, R. Blouet, and J.-L. Durrieu, "Multichannel nonnegative tensor factorization with structured constraints for user-guided audio source separation," in IEEE International Conference on Acoustics, Speech, and Signal Processing (ICASSP'11), Prague, May 2011, pp. 257-260.

[19] V. Emiya, E. Vincent, N. Harlander, and V. Hohmann, "Subjective and objective quality assessment of audio source separation," IEEE Trans. Audio, Speech, Language Process., vol. 19, no. 7, pp. 2046-2057, 2011.

**Claims**

1. A method for encoding multiple audio signals, comprising steps of

   - random sampling and quantizing each of the multiple audio signals; and
   - encoding the sampled and quantized multiple audio signals as side information that can be used for decoding and separating the multiple audio signals from a mixture of said multiple audio signals.

2. The method according to claim 1, wherein the random sampling uses a predefined pseudo-random pattern.

3. The method according to claim 1 or 2, wherein the mixture of multiple audio signal is progressively encoded as it arrives.

4. A method for decoding a mixture of multiple audio signals, comprising steps of

   - decoding and demultiplexing side information, the side information comprising quantized samples of each of the multiple audio signals;
   - receiving or retrieving, from storage or any data source, a mixture of said multiple audio signals; and
   - generating multiple estimated audio signals that approximate said multiple audio signals, wherein said quantized samples of each of the multiple audio signals are used.

5. The method according to claim 4, wherein the step of generating multiple estimated audio signals comprises steps of

   - computing a variance tensor Vfrom random nonnegative values;
   - computing conditional expectations of the source power spectra of the quantized samples of the multiple audio signals, wherein estimated source power spectra $P(f,n,j)$ are obtained and wherein the variance tensor V and complex Short-Time Fourier Transform (STFT) coefficients of the multiple audio signals are used;

- iteratively re-calculating the variance tensor $V$ from the estimated source power spectra $P(f,n,j)$;
- computing an array of STFT coefficients $\hat{S}$ from the resulting variance tensor $V$; and
- converting the array of STFT coefficients $\hat{S}$ to the time domain, wherein the multiple estimated audio signals are obtained.

6. The method according to claim 4 or 5, further comprising audio inpainting for at least one of the multiple audio signals.

7. An apparatus for encoding multiple audio signals, comprising a processor and a memory storing instructions that, when executed, cause the apparatus to perform a method for encoding multiple audio signals that comprises steps of

- random sampling and quantizing each of the multiple audio signals; and
- encoding the sampled and quantized multiple audio signals as side information that can be used for decoding and separating the multiple audio signals from a mixture of said multiple audio signals.

8. The apparatus according to claim 7, wherein the random sampling uses a predefined pseudo-random pattern.

9. An apparatus for decoding a mixture of multiple audio signals, comprising a processor and a memory storing instructions that, when executed, cause the apparatus to perform a method for decoding a mixture of multiple audio signals that comprises

- decoding and demultiplexing side information, the side information comprising quantized samples of each of the multiple audio signals;
- receiving or retrieving, from storage or any data source, a mixture of said multiple audio signals; and
- generating multiple estimated audio signals that approximate said multiple audio signals, wherein said quantized samples of each of the multiple audio signals are used.

10. The apparatus according to claim 9, wherein the step of generating multiple estimated audio signals comprises steps of

- computing a variance tensor $V$ from random nonnegative values;
- computing conditional expectations of the source power spectra of the quantized samples of the multiple audio signals, wherein estimated source power spectra $P(f,n,j)$ are obtained and wherein the variance tensor V and complex Short-Time Fourier Transform (STFT) coefficients of the multiple audio signals are used;
- iteratively re-calculating the variance tensor $V$ from the estimated source power spectra $P(f,n,j)$;
- computing an array of STFT coefficients $\hat{S}$ from the resulting variance tensor $V$; and
- converting the array of STFT coefficients $\hat{S}$ to the time domain, wherein the multiple estimated audio signals are obtained.

11. The apparatus according to claim 9 or 10, further comprising audio inpainting for at least one of the multiple audio signals.

Fig.1

ENCODER

a)

b)

Fig.2

Fig.3

Fig.4

Europäisches
Patentamt

European
Patent Office

Office européen
des brevets

# EUROPEAN SEARCH REPORT

**Application Number**

EP 15 30 6144

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Cagdas Bilen ET AL: "Compressive sampling-based informed source separation", IEEE Workshop on Applications of Signal Processing to Audio and Acoustics, 8 July 2014 (2014-07-08), XP055216391, Retrieved from the Internet: URL:https://hal.inria.fr/hal-01171833/document [retrieved on 2015-09-28] * the whole document * | 1-11 | INV. G10L19/008 G10L21/0272 ADD. H03M1/12 |
| X | Cagdas Bilen ET AL: "Audio Inpainting, Source Separation, Audio Compression. All with a Unified Framework Based on NTF Model", MissData 2015, 18 June 2015 (2015-06-18), pages 1-2, XP055216560, Retrieved from the Internet: URL:https://hal.inria.fr/hal-01171843/document [retrieved on 2015-09-28] | 1,3-7, 9-11 | |
| Y | * the whole document * | 2,8 | TECHNICAL FIELDS SEARCHED (IPC) G10L H03M |
| X | Cagdas Bilen ET AL: "Audio Inpainting, Source Separation, Audio Compression. All with a Unified Framework Based on NTF Model", MissDATA 2015 (slides), 18 June 2015 (2015-06-18), pages 31/60 (1/15)-45/60 (15/15), XP055216546, Rennes, France Retrieved from the Internet: URL:http://arxiv.org/abs/1502.06919 [retrieved on 2015-09-28] | 1,3-7, 9-11 | |
| Y | * (4/15) - (14/15); page 34 - page 44 * | 2,8 | |

-/--

The present search report has been drawn up for all claims

| Place of search | Date of completion of the search | Examiner |
|---|---|---|
| Munich | 6 October 2015 | Virette, David |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P04C01)

Europäisches
Patentamt

European
Patent Office

Office européen
des brevets

# EUROPEAN SEARCH REPORT

Application Number

EP 15 30 6144

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | CANDES E J ET AL: "An Introduction To Compressive Sampling", IEEE SIGNAL PROCESSING MAGAZINE, IEEE SERVICE CENTER, PISCATAWAY, NJ, US, vol. 25, no. 2, March 2008 (2008-03), pages 21-30, XP011225660, ISSN: 1053-5888, DOI: 10.1109/MSP.2007.914731 * page 29, paragraph 1) Nonuniform Sampler (NUS) - paragraph 2) Random Modulation Preintegration (RMPI) * | 2,8 | |
| X | VIRTANEN TUOMAS ET AL: "Compositional Models for Audio Processing: Uncovering the structure of sound mixtures", IEEE SIGNAL PROCESSING MAGAZINE, IEEE SERVICE CENTER, PISCATAWAY, NJ, US, vol. 32, no. 2, March 2015 (2015-03), pages 125-144, XP011573080, ISSN: 1053-5888, DOI: 10.1109/MSP.2013.2288990 [retrieved on 2015-02-10] | 1,4,7,9 | |
| A | * page 125, line 9 - page 126, left-hand column, line 10 * * page 132, paragraph Source separation - page 134, paragraph Dictionary creation * | 2,3,5,6, 8,10,11 | TECHNICAL FIELDS SEARCHED (IPC) |
| A,D | OZEROV A ET AL: "Coding-Based Informed Source Separation: Nonnegative Tensor Factorization Approach", IEEE TRANSACTIONS ON AUDIO, SPEECH AND LANGUAGE PROCESSING, IEEE SERVICE CENTER, NEW YORK, NY, USA, vol. 21, no. 8, August 2013 (2013-08), pages 1699-1712, XP011519779, ISSN: 1558-7916, DOI: 10.1109/TASL.2013.2260153 * page 1700, paragraph II. - page 1705, paragraph III.D.1) * | 1-11 | |

The present search report has been drawn up for all claims

| Place of search | Date of completion of the search | Examiner |
|---|---|---|
| Munich | 6 October 2015 | Virette, David |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

                     

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. VINCENT ; S. ARAKI ; F. J. THEIS ; G. NOLTE ; P. BOFILL ; H. SAWADA ; A. OZEROV ; B. V. GOWREESUNKER ; D. LUTTER ; N. Q. K. DUONG.** The signal separation evaluation campaign (2007-2010): Achievements and remaining challenges. *Signal Processing,* 2007, vol. 92 (8), 1928-1936
- **M. PARVAIX ; L. GIRIN ; J.-M. BROSSIER.** A watermarkingbased method for informed source separation of audio signals with a single sensor. *IEEE Trans. Audio, Speech, Language Process.,* 2010, vol. 18 (6), 1464-1475
- **M. PARVAIX ; L. GIRIN.** Informed source separation of linear instantaneous under-determined audio mixtures by source index embedding. *IEEE Trans. Audio, Speech, Language Process.,* 2011, vol. 19 (6), 1721-1733
- **A. LIUTKUS ; J. PINEL ; R. BADEAU ; L. GIRIN ; G. RICHARD.** Informed source separation through spectrogram coding and data embedding. *Signal Processing,* 2012, vol. 92 (8), 1937-1949
- **A. OZEROV ; A. LIUTKUS ; R. BADEAU ; G. RICHARD.** Coding-based informed source separation: Nonnegative tensor factorization approach. *IEEE Transactions on Audio, Speech, and Language Processing,* August 2013, vol. 21 (8), 1699-1712
- **J. ENGDEGARD ; B. RESCH ; C. FALCH ; O. HELLMUTH ; J. HILPERT ; A. H" OLZER ; L. TERENTIEV ; J. BREEBAART ; J. KOPPENS ; E. SCHUIJERS.** Spatial audio object coding (SAOC) - The upcoming MPEG standard on parametric object based audio coding. *124th Audio Engineering Society Convention (AES 2008),* May 2008
- **A. OZEROV ; A. LIUTKUS ; R. BADEAU ; G. RICHARD.** Informed source separation: source coding meets source separation. *IEEE Workshop Applications of Signal Processing to Audio and Acoustics (WASPAA'11),* October 2011, 257-260
- **S. KIRBIZ ; A. OZEROV ; A. LIUTKUS ; L. GIRIN.** Perceptual coding-based informed source separation. *Proc. 22nd European Signal Processing Conference (EUSIPCO),* 2014, 959-963

- **Z. XIONG ; A. D. LIVERIS ; S. CHENG.** Distributed source coding for sensor networks. *IEEE Signal Processing Magazine,* September 2004, vol. 21 (5), 80-94
- **B. GIROD ; A. AARON ; S. RANE ; D. REBOLLO-MONEDERO.** Distributed video coding. *Proceedings of the IEEE,* January 2005, vol. 93 (1), 71-83
- **D. DONOHO.** Compressed sensing. *IEEE Trans. Inform. Theory,* April 2006, vol. 52 (4), 1289-1306
- **R. G. BARANIUK.** Compressive sensing. *IEEE Signal Processing Mag,* July 2007, vol. 24 (4), 118-120
- **E. J. CANDES ; M. B. WAKIN.** An introduction to compressive sampling. *IEEE Signal Processing Magazine,* 2008, vol. 25, 21-30
- **R. G. BARANIUK ; V. CEVHER ; M. F. DUARTE ; C. HEGDE.** Model-based compressive sensing. *IEEE Trans. Info. Theory,* April 2010, vol. 56 (4), 1982-2001
- **C. FEVOTTE ; N. BERTIN ; J.-L. DURRIEU.** Nonnegative matrix factorization with the Itakura-Saito divergence. With application to music analysis. *Neural Computation,* March 2009, vol. 21 (3), 793-830
- **A. P. DEMPSTER ; N. M. LAIRD ; D. B. RUBIN.** Maximum likelihood from incomplete data via the EM algorithm. *Journal of the Royal Statistical Society. Series B (Methodological),* 1977, vol. 39, 1-38
- **S.M. KAY.** Fundamentals of Statistical Signal Processing: Estimation Theory. Englewood Cliffs, NJ: Prentice Hall, 1993
- **A. OZEROV ; C. FEVOTTE ; R. BLOUET ; J.-L. DURRIEU.** Multichannel nonnegative tensor factorization with structured constraints for user-guided audio source separation. *IEEE International Conference on Acoustics, Speech, and Signal Processing (ICASSP'11),* May 2011, 257-260
- **V. EMIYA ; E. VINCENT ; N. HARLANDER ; V. HOHMANN.** Subjective and objective quality assessment of audio source separation. *IEEE Trans. Audio, Speech, Language Process.,* 2011, vol. 19 (7), 2046-2057